# EUROPEAN PATENT APPLICATION

(11) **EP 4 756 812 A1**
(43) Date of publication of application: **10.06.2026**
(21) Application number: 25184721.6
(22) Date of filing: 24.06.2025
(51) Int. Cl.: G11C 16/28, G11C 17/16, G11C 17/18

(54) **METHOD AND CIRCUIT FOR BIT READ DURING NON-VOLATILE MEMORY POWER-ON-RESET**

(30) Priority: 09.12.2024 US 202418973257
(71) Applicant: GlobalFoundries U.S. Inc., Malta, NY 12020 (US)
(72) Inventor: Gopinath, Venkatesh Periyapatna, Santa Clara, 95054 (US); Chinthu, Siva Kumar, 560045 Bangalore (IN); Saraswat, Vivek, 560045 Bangalore (IN)
(74) Representative: Grünecker Patent- und Rechtsanwälte PartG mbB

(57) **Abstract**

Embodiments of the present disclosure provide a memory circuit, including: a non-volatile memory; a one-time-programmable memory; a sense amplifier coupled to the non-volatile memory and the one-time-programmable memory; a digital register coupled to an output of the sense amplifier for storing reference resistance bits; control logic coupled to an output of the digital register; a decoder coupled to an output of the control logic; and a controller for outputting a control signal to the control logic to select a first reference resistance for the sense amplifier from the decoder for a reading of bits from the one-time-programmable memory, and to select a second reference resistance for the sense amplifier from the decoder for a reading of bits from the non-volatile memory.

## Description

### BACKGROUND

Embodiments of the disclosure relate generally to integrated circuits. More specifically, the disclosure provides a method and circuit for bit read during non-volatile memory power-on-reset (POR).

Non-volatile memory (NVM) is a type of memory that retains stored content even when power is removed. Electrically erasable programmable read-only memory (EEPROM) and flash memory are two common types of NVM memories. In particular, flash memory has become widely used in electronic devices, especially portable electronic devices, because of its ability to provide data storage at low power levels.

The operation of an NVM memory typically requires specified and stable reference voltages and current values to ensure proper circuit operation. Due to fabrication process variations, the voltage or current values generated by internal or on-chip reference sources often vary from chip to chip. To set the desired operating point for an internal reference source, adjustments to the integrated circuit may be performed to fine tune the internal reference sources to the desired operating points. The adjustment process is referred to as trimming and the adjustments are typically made through trim bits that are stored in a portion of the NVM memory to set the desired operating point of the internal reference sources.

In an NVM memory, trimming is used not only to adjust internal analog voltage/current levels to desired target levels but may also be used for compensating for temperature, or to enable/disable special internal features. In order to conserve silicon real estate, an NVM memory often includes a dedicated area (e.g., a one-time programmable (OTP) memory) for storing the trim data. Upon powering up of the NVM memory, the trim data are read out from the OTP memory in a normal memory read operation and applied to the respective circuitry of the NVM memory. However, in some cases, it may not be possible to correctly read out the trim data from the NVM memory upon power-up and before adjustments of the analog levels can be applied.

OTP memory is a type of memory that can only be programmed once to store data permanently, but which ideally can be read an infinite number of times. OTP memory may be used to store trim data, identification information for an integrated circuit, firmware (e.g., BIOS), security data, and the like. The trim data may include, for example, configuration data for an integrated circuit and/or data to compensate for process variability that may occur during fabrication of an integrated circuit.

A portion of the NVM memory may be configured as an OTP memory to store trim data for the initialization of the NVM memory during a POR process. In some cases, the OTP memory may include a plurality of fuses that have been selectively "blown" to program trim data into the OTP memory as trim bits. Once blown, the resulting bits in the OTP memory have a much higher resistance than the bits in the NVM memory. In another implementation, the bits as fabricated may have a very high resistance and certain bits can be programmed to attain very low resistance, or a short, to store trim data as an OTP memory. After programming, the trim bits may be read out of the OTP memory and used to configure the NVM memory during the POR process.

Data stored in the OTP memory and the NVM memory may be read using a sense amplifier. However, the read reference resistance for the sense amplifier may be suitable for the reading of bits from one of the OTP memory or the NVM memory, but not both. This is because the OTP memory has more stringent retention requirements under stress, such as thermal stress, which can cause the resistance of the bits to drift with time, compared to the NVM memory. Further, the optimal reference resistance for a sense amplifier is different for OTP and NVM memories. Using a single reference resistance level, therefore, may result in faulty data being read out of the OTP memory or the NVM memory during a POR event.

### SUMMARY

Aspects of the disclosure provide a memory circuit, including: a non-volatile memory; a one-time-programmable memory; a sense amplifier coupled to the non-volatile memory and the one-time-programmable memory; a digital register coupled to an output of the sense amplifier for storing reference resistance bits; control logic coupled to an output of the digital register; a decoder coupled to an output of the control; and a controller for outputting a control signal to the control logic to select a first reference resistance for the sense amplifier from the decoder for a reading of bits from the one-time-programmable memory, and to select a second reference resistance for the sense amplifier from the decoder for a reading of bits from the non-volatile memory. The selection is based on whether the circuit is in power on reset mode (or OTP read mode) or normal read mode.

Another aspect of the disclosure includes a method for accessing memory, the memory including a non-volatile memory, a one-time-programmable memory, and a sense amplifier coupled to the non-volatile memory and the one-time-programmable memory, the method including: storing reference resistance bits in a digital register; and outputting a control signal to control logic for selecting a first reference resistance for the sense amplifier from a decoder for a reading of bits from the one-time-programmable memory, and for selecting a second reference resistance for the sense amplifier from the decoder for a reading of bits from the non-volatile memory.

### BRIEF DESCRIPTION OF THE DRAWINGS

FIG. 1 depicts a conventional circuit for reading data from a one-time programmable (OTP) memory and a non-volatile memory (NVM) during a power-on-reset (POR) process.
FIG. 2 depicts a circuit for reading data from an OTP memory and an NVM memory during a POR process according to embodiments of the disclosure.
FIG. 3 depicts the circuit of FIG. 2 in greater detail according to embodiments of the disclosure.
FIG. 4 depicts the circuit of FIG. 3 during the reading of trim fuse bits from the OTP memory during a POR process according to embodiments of the disclosure.
FIG. 5 depicts the circuit of FIG. 3 during the reading of NVM data bits from the NVM memory during a POR process according to embodiments of the disclosure.
FIG. 6 depicts the circuit of FIG. 3 during the reading of trim fuse bits from the OTP memory during a POR process according to additional embodiments of the disclosure.
FIG. 7 depicts the circuit of FIG. 3 during the reading of data bits from the OTP memory during a POR process according to additional embodiments of the disclosure.
FIG. 8 depicts the sense amplifier of FIG. 2 in greater detail according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific exemplary embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

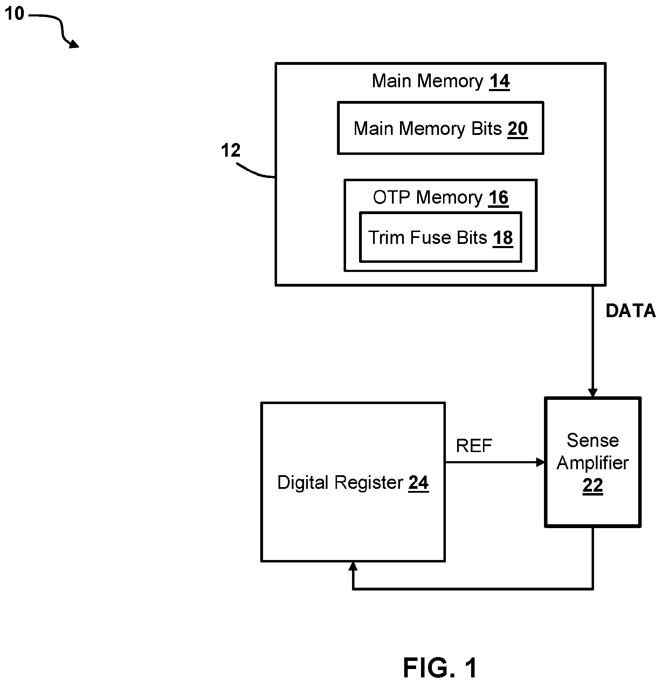

FIG. 1 depicts a conventional circuit 10 for reading data from a non-volatile memory (NVM) array 12 including a main memory 14 and a one-time programmable (OTP) memory 16 during a power-on-reset (POR) process. The OTP memory 16 may be formed from a portion of the main memory 14. The OTP memory 16 may include a plurality of fuses (not shown) that have been selectively "blown" to program trim data into the OTP memory 16 as trim fuse bits 18. After programming, the trim fuse bits 18 may be read out of the OTP memory 16 and used to configure the circuit 10 during the POR process.

An OTP control byte may be used to permanently lock the portion of the main memory 14 used for the OTP memory 16 after the programming of the trim fuse bits 18. For example, one or more bits in the OTP control byte may be set to a first state to allow the trim fuse bits 18 to be programmed in the OTP memory 16. When the relevant bits of the OTP control byte are set to a second state opposite the first state, the OTP memory 16 becomes read-only and cannot be programmed again. For instance, once the relevant bits in the OTP control byte are set to the second state, those data bits cannot be set back to the first state again. Thus, once the relevant bits in the OTP control byte are set to the second state, the entire OTP memory 16 becomes read-only in a permanent way. Any program or erase cycle applied to the OTP memory 16 thereafter is rejected.

Main memory bits 20 stored in the main memory 14 and trim fuse bits 18 stored the OTP memory 16 may be selectively accessed in a conventional manner by a row decoder and a column decoder for read, program (write) and erase operations. During a read operation, the trim fuse bits 18 stored the OTP memory 16 and the main memory bits 20 stored in the main memory 14 may be read by a sense amplifier 22, which may be configured to measure the current flowing through the cells of the main memory 14 and the OTP memory 16. In practice, the sense amplifier 22 may include a bank of sense amplifiers (or sense amplifier circuits), one sense amplifier for each input/output (I/O) of the memory array 12. In the following description, however, the operation of the memory array 12 is described with reference to a single sense amplifier 22.

The sense amplifier 22 is coupled to a digital register 24 for storing the trim fuse bits 18 read out of the OTP memory 16 by the sense amplifier 22 during a POR process. The trim fuse bits 18 stored in the digital register 24 include reference resistance bits, which are read out of the digital register 24 as a reference resistance REF by the sense amplifier 22. The reference resistance REF is typically set to a value that is optimal for reading the main memory bits 20 from the main memory 14, but suboptimal for reading the trim fuse bits 18 from the OTP memory 16. For example, to accurately read the trim fuse bits 18 from the OTP memory 16 during a POR read, the sense amplifier 22 may require a reference resistance REF that is much greater than the reference resistance REF required by the sense amplifier 22 when reading the main memory bits 20 from the main memory 14. This may result in faulty data being read out of the OTP memory 16.

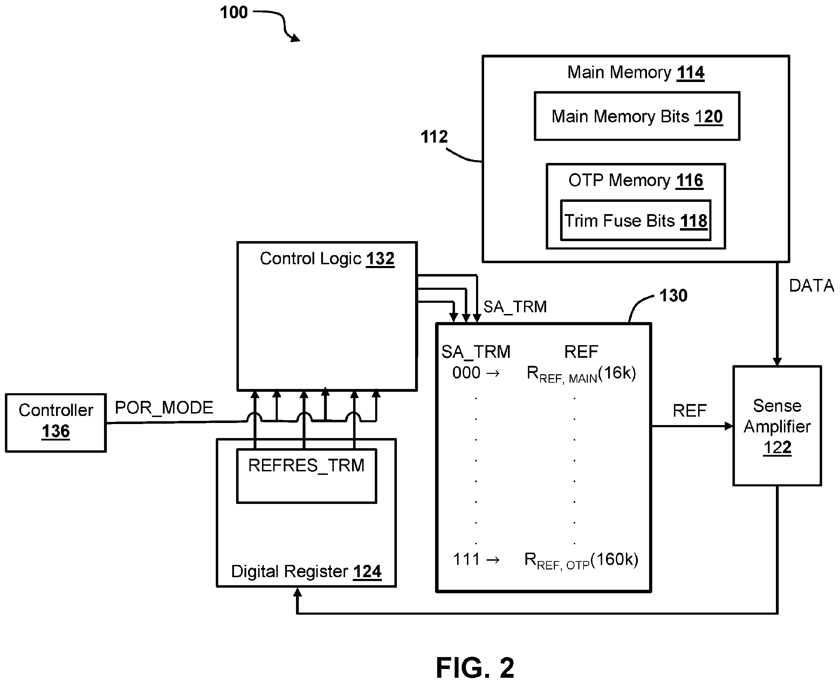

FIG. 2 depicts a circuit 100 for reading data from a NVM array 112 including a main memory 114 and an OTP memory 116 during a POR process according to embodiments of the disclosure. Similar to the OTP memory 16 depicted in FIG. 1, the OTP memory 116 may be formed from a portion of the main memory 114 by selectively blowing a plurality of fuses (not shown) to program trim data into predefined trim addresses of the OTP memory 116 as trim fuse bits 118. Alternatively, the OTP memory 116 may be separate from the main memory 114. After programming, the trim fuse bits 118 may be read out of the OTP memory 116 and used to configure the circuit 100 during the POR process. However, unlike the conventional circuit 10 described above, the circuit 100 according to embodiments of the disclosure is configured to provide different reference resistances REF to the sense amplifier 122 during the POR process, depending on which of the OTP memory 116 or main memory 114 is currently being read by the sense amplifier 122.

Main memory bits 120 stored in the main memory 114 and trim fuse bits 118 stored the OTP memory 116 may be selectively accessed (e.g., via a row decoder and a column decoder) during read, program (write) and erase operations. During a read operation, the sense amplifier 122 may be used to read the trim fuse bits 118 stored the OTP memory 116 and the main memory bits 120 stored in the main memory 114. The sense amplifier 122 may be configured to measure the current flowing through the cells of the main memory 114 and the OTP memory 116. For example, the sense amplifier 122 may compare the current flowing through memory cells of the main memory 114 and the OTP memory 116 against a reference current flowing through a reference resistance set according to the reference resistance REF output by the decoder 130, and generate a digital readout of the comparison. Although depicted as a single sense amplifier 122 in FIG. 2, the sense amplifier 122 may be implemented using a bank of sense amplifiers (or sense amplifier circuits), where each sense amplifier is coupled to a respective input/output (I/O) of the NVM array 112. In the following description, however, the operation of the NVM array 112 is again described with reference to a single sense amplifier 122.

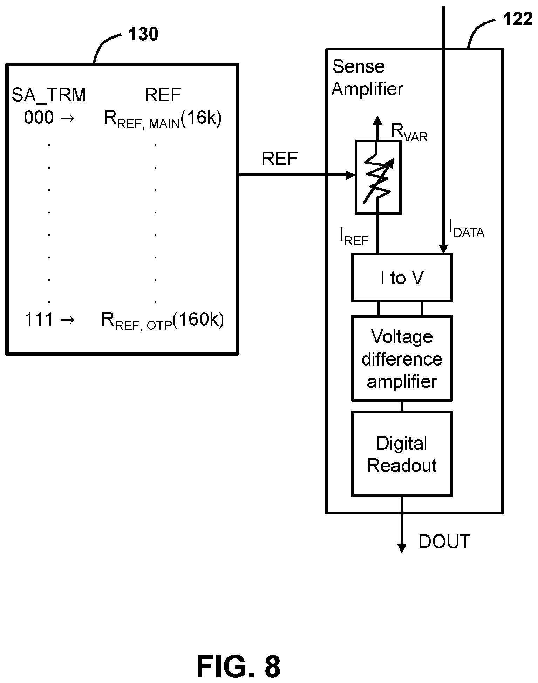

An illustrative sense amplifier 122 according to embodiments of the disclosure is depicted in FIG. 8. As shown, the sense amplifier 122 may include a variable resistance R_{VAR} that is set based on the reference resistance REF output from the decoder 130. The sense amplifier 122 compares the current I_{REF} flowing through the variable resistance R_{VAR} to the current I_{DATA} flowing through the memory cells of the main memory 114 and the OTP memory 116. The result of the comparison between the current I_{REF} and the measured current I_{DATA} is converted to a voltage value, amplified, and output as a digital value.

The sense amplifier 122 is coupled to a digital register 124, which is configured to store the trim fuse bits 118 read out of the OTP memory 116 by the sense amplifier 122 (e.g., during a POR process). The trim fuse bits 118 stored in the digital resistor 124 may include reference resistance REFRES_TRM bits that are used in the selection of a reference resistance REF from a decoder 130. Alternatively, the reference resistance REFRES_TRM bits may be stored in the digital register 124 prior to a POR process.

The decoder 130 is coupled to the sense amplifier 122. The decoder 130 is used to select a reference resistance REF from a plurality of reference resistances REF, where the selected reference resistance REF is provided to the sense amplifier 122. According to embodiments of the disclosure, the reference resistance REF may vary from a resistance R_{REF, MAIN}, which is optimal for the reading of the main memory bits 120 from the main memory 114 to a resistance R_{REF, OTP}, which is optimal for the reading of the trim fuse bits 118 from the OTP memory 116, where R_{REF, MAIN} << R_{REF, OTP}. For example, in the non-limiting example depicted in FIG. 2, R_{REF, MAIN} may be 16k ohms for the reading of the main memory bits 120 from the main memory 114, while R_{REF, OTP} may be 160k ohms for the reading of the trim fuse bits 118 from the OTP memory 116.

The outputs of control logic 132 are coupled to the decoder 130. According to embodiments of the disclosure, the control logic 132 is configured to output an address SA_TRM to the decoder 130 for selecting a reference resistance REF for the sense amplifier 122 based on the value of a signal POR_MODE from a controller 136 during the POR process and the reference resistance REFRES_TRM bits stored in the digital register 124.

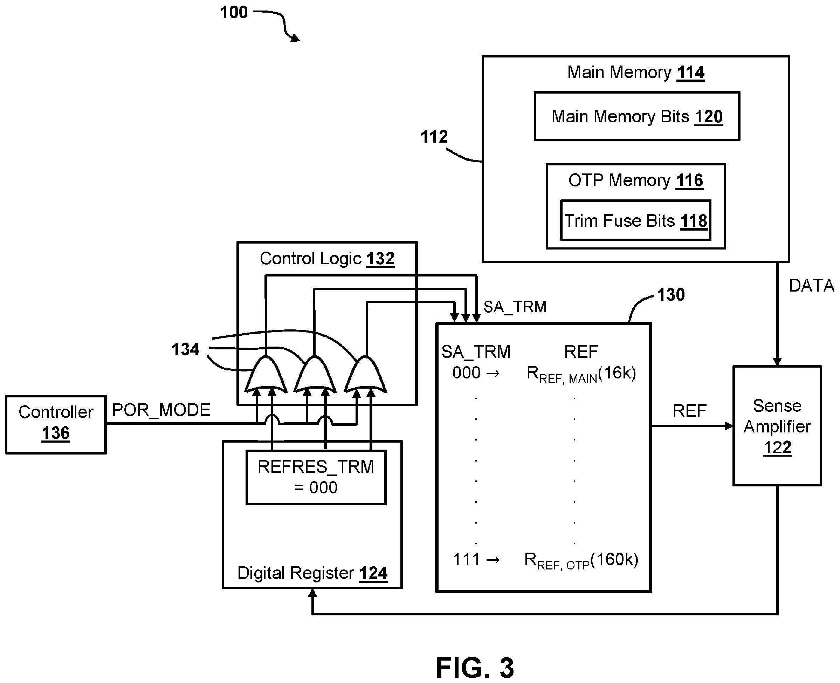

According to embodiments of the disclosure, as depicted in FIG 3, the control logic 132 may include a plurality of OR gates 134 (e.g., 3 OR gates). A first input of each OR gate 134 of the plurality of OR gates 134 is coupled to the controller 136 and receives a POR_MODE signal from the controller 136. Each bit of the reference resistance REFRES_TRM bits stored in the digital register 124 is coupled to a second input of a respective OR gate 134 of the plurality of OR gates 134. The outputs of the plurality of OR gates 134 provide the address SA_TRM for selecting a reference resistance REF implemented in the decoder 130.

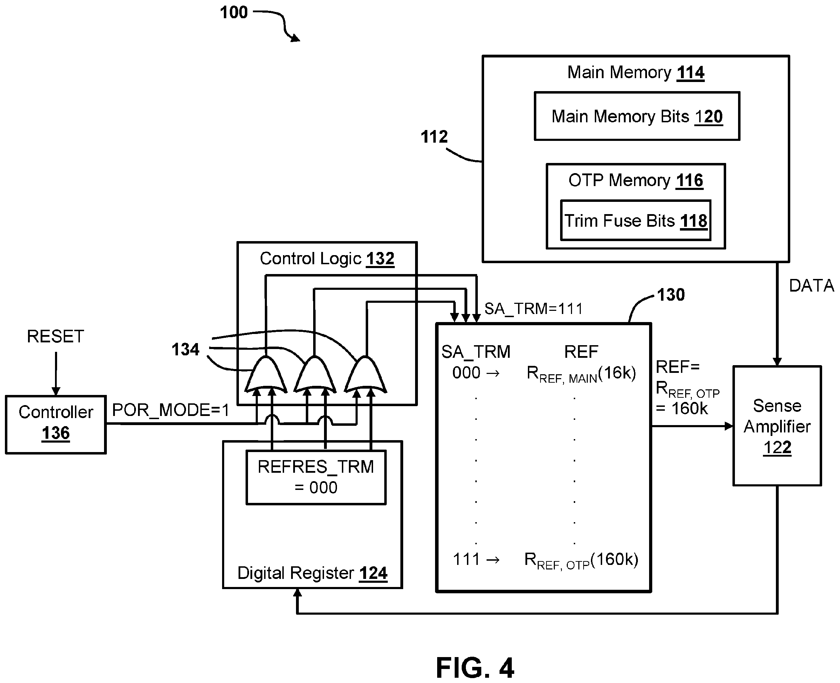

According to embodiments of the disclosure, each bit of the reference resistance REFRES_TRM bits read into (or otherwise stored in) the digital register 124 may be set to a logic 0 value (e.g., 000). As depicted in FIG. 4, for example, when the controller 136 receives a reset command RESET at the start of a POR process, the controller 136 outputs a signal POR_MODE = 1 to the first input of each OR gate 134 of the plurality of OR gates 134. Each second input of the plurality of OR gates 134 is coupled to a respective bit of the reference resistance REFRES_TRM bits (000). To this extent, the first input of each OR gate 134 is set to a logic 1 value, while the second input of each OR gate 134 of the plurality of OR gates 134 is set to a logic 0 value. The output of each OR gate 134 of the plurality of OR gates 134 is thus set to a logic 1 value such that the address SA_TRM output by the control logic 132 to the decoder 130 is 111.

Three OR gates 134 are depicted in FIG. 3 for outputting a three bit address SA_TRM to the decoder 130. However, the number of OR gates 134 may vary depending on the addressing requirements of the decoder 130.

As shown in FIG. 4, when POR_MODE =1, the three OR gates 134 of the control logic 132 output a three bit address SA_TRM = 111 to the decoder 130. In response to the address SA_TRM = 111 provided by the plurality of OR gates 134, the decoder 130 outputs a reference resistance REF = R_{REF, OTP} (e.g., 160k ohms) to the sense amplifier 122, which is optimal for the reading of the trim fuse bits 118 from the OTP memory 116. The trim fuse bits 118 may then be read from the OTP memory 116 by the sense amplifier 122 using a reference resistance REF = R_{REF, OTP}.

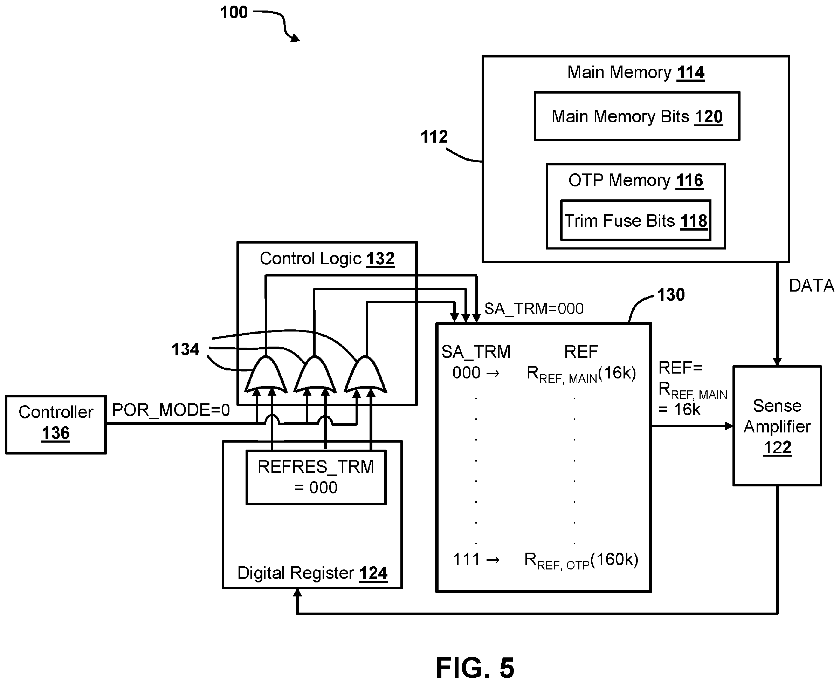

As depicted in FIG. 5, after the controller 136 determines that all of the trim fuse data 118 have been read out of the predefined trim addresses of the OTP memory 116, the controller 136 outputs a signal POR_MODE = 0 to the first input of each OR gate 134 of the plurality of OR gates 134. To this extent, both inputs of each OR gate 134 are set to a logic 0 value. The output of each OR gate 134 of the plurality of OR gates 134 is thus set to a logic 0, and a three bit address SA_TRM = 000 is output by the plurality of OR gates 136 to the decoder 130.

In response to the address SA_TRM = 000 output by the plurality of OR gates 134 of the control logic 132, the decoder 130 now outputs a reference resistance REF = R_{REF, MAIN} (e.g., 16k ohms) to the sense amplifier 122, which is optimal for the reading of the main memory bits 120 from the main memory 114. The main memory bits 120 may then be read by the sense amplifier 122 using a reference resistance REF = R_{REF, MAIN}.

Summarizing the operation of the circuit 100:
When POR_MODE = 1, SA_TRM = 111, REF = R_{REF, OTP}, and
When POR_MODE = 0, SA_TRM = 000, REF = R_{REF, MAIN}.
Advantageously, different optimal reference resistances REF may be provided to the sense amplifier 122 for the reading of the trim fuse bits 118 from the OTP memory 116 and the subsequent reading of the main memory bits 120 from the main memory 114 during the POR process.

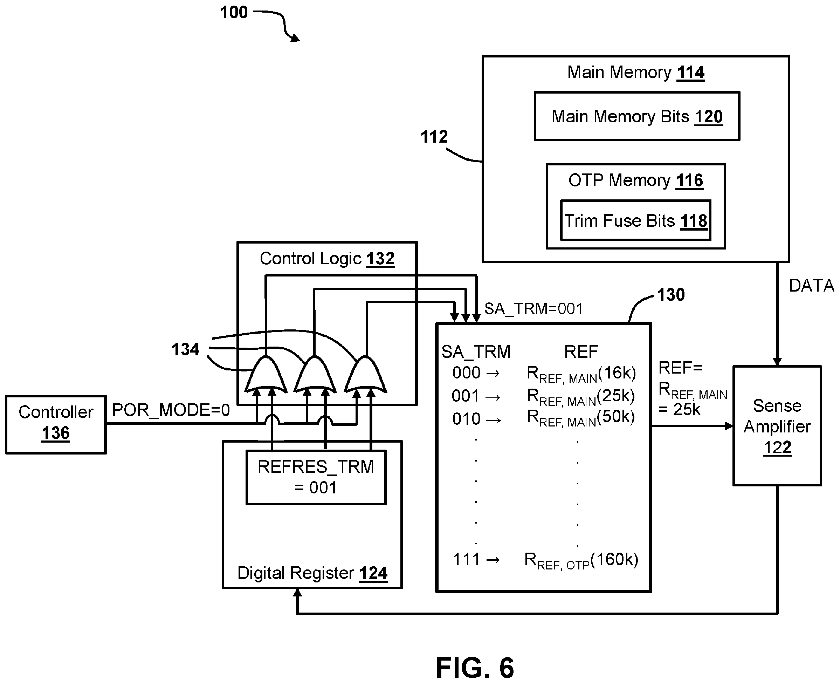

Additional reference resistances REF = R_{REF, MAIN} may be implemented in the decoder 130, and a different reference resistance R_{REF, MAIN} may be selected from the decoder 130 and provided to the sense amplifier 122. As depicted in FIG. 6, this may be achieved, for instance, by storing a different set of reference resistance REFRES_TRM bits in the digital register 124 such that a different address SA_TRM is output by the plurality of OR gates 134. For example, when REFRES_TRM = 001, then a reference resistance R_{REF, MAIN} = 25k ohms stored at address SA_TRM = 001 of the decoder 130 is selected when POR_MODE = 0. Other reference resistances R_{REF, MAIN} may be selected from the decoder 130 and provided to the sense amplifier 122 by providing different values of the reference resistance REFRES_TRM bits.

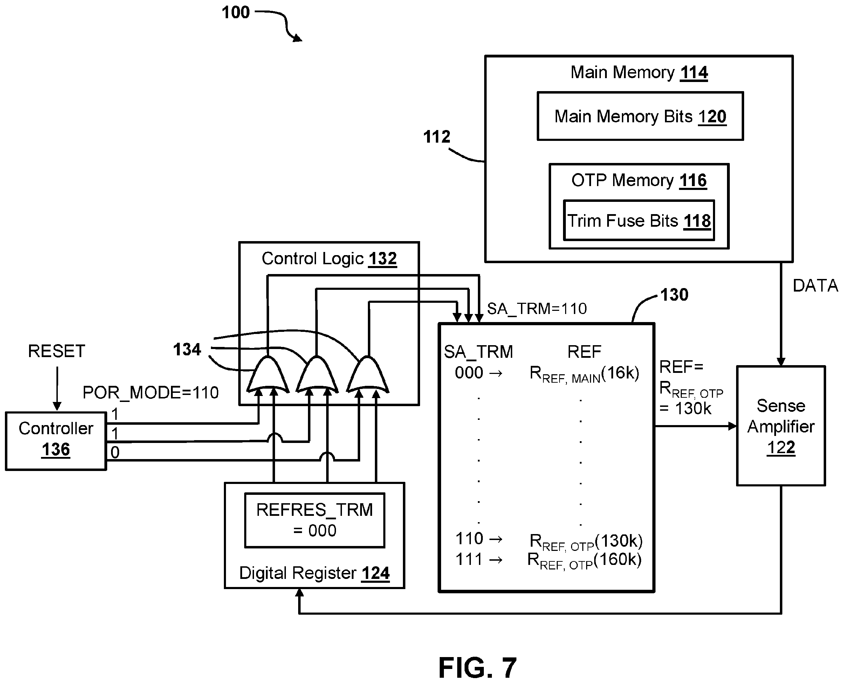

Additional reference resistances REF = R_{REF, OTP} may also be implemented in the decoder 130 such that different reference resistances R_{REF, OTP} may be selected by the decoder 130 and provided to the sense amplifier 122. As depicted in FIG. 7, this may be achieved, for instance, by the controller 136 outputting a multi-bit POR_MODE signal to the first inputs of the plurality of OR gates 134 in response to the RESET signal. For example, if the controller 136 outputs a POR_MODE = 110 signal to the first inputs of the plurality of OR gates, and assuming that REFRS_TRM = 000, then an address SA_TRM = 110 is provided to the decoder 130. As a result, a reference resistance of REF = R_{REF, OTP} corresponding to address SA_TRM = 110 (e.g., 130k ohm) is output to the sense amplifier 122.

From the above discussion, it should be clear that different combinations of the control logic 132, the POR_MODE signal output by the controller 136, and the reference resistance REFRES_TRM bits stored in the digital register 124 may be used to selectively generate an address SA_TRM for the decoder 130. For example, the control logic 132 may include NOR gates in place of the OR gates 134 depicted in FIGS. 3-7. In this case, the reference resistance REF = R_{REF, OTP} may be selected by the decoder 130 in response to the controller 136 outputting signal POR_MODE = 0 to the first input of each of the NOR gates in response to the RESET signal. Assuming that REFRS_TRM = 000, then the NOR gates of the control logic 132 would output an address of SA_TRM = 111 to the decoder 130, corresponding to the reference resistance REF = R_{REF,} OTP.

The method and structure as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a center processor.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and
s, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/- 10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, embodiments of the present disclosure provide a memory circuit, including: a non-volatile memory; a one-time-programmable memory; a sense amplifier coupled to the non-volatile memory and the one-time-programmable memory; a digital register coupled to an output of the sense amplifier for storing reference resistance bits; control logic coupled to an output of the digital register; a decoder coupled to an output of the control logic; and a controller for outputting a control signal to the control logic to select a first reference resistance for the sense amplifier from the decoder for a reading of bits from the one-time-programmable memory, and to select a second reference resistance for the sense amplifier from the decoder for a reading of bits from the non-volatile memory.
The following embodiments are explicitly disclosed.

### Embodiment 1:

A memory circuit, comprising:
a non-volatile memory;
a one-time-programmable memory;
a sense amplifier coupled to the non-volatile memory and the one-time-programmable memory;
a digital register coupled to an output of the sense amplifier for storing reference resistance bits;
control logic coupled to an output of the digital register;
a decoder coupled to an output of the control logic; and
a controller for outputting a control signal to the control logic to select a first reference resistance for the sense amplifier from the decoder for a reading of bits from the one-time-programmable memory, and to select a second reference resistance for the sense amplifier from the decoder for a reading of bits from the non-volatile memory.

### Embodiment 2:

The memory circuit according to embodiment 1, wherein the first reference resistance is greater than the second reference resistance.

### Embodiment 3:

The memory circuit according to embodiment 1 or 2, wherein a portion of the non-volatile memory includes the one-time-programmable memory.

### Embodiment 4:

The memory circuit according to one of embodiments 1 to 3, wherein the controller outputs the control signal to the control logic during a power-on-reset process.

### Embodiment 5:

The memory circuit according to one of embodiments 1 to 4, wherein the bits read from the one-time-programmable memory include trim fuse bits.

### Embodiment 6:

The memory circuit according to one of embodiments 1 to 5, wherein the control logic outputs an address to the decoder for selecting a reference resistance from the decoder.

### Embodiment 7:

The memory circuit according to one of embodiments 1 to 6, wherein the control signal output by the controller has a first value for the reading of bits from the one-time-programmable memory, and wherein the control signal output by the controller has a second value for the reading of bits from the non-volatile memory.

### Embodiment 8:

The memory circuit according to one of embodiments 1 to 7, wherein the control logic comprises a plurality of OR gates, wherein a first input of each OR gate of the plurality of OR gates receives the control signal output by the controller.

### Embodiment 9:

The memory circuit according to one of embodiments 1 to 8, wherein a second input of each OR gate of the plurality of OR gates receives a respective bit of the reference resistance bits stored in the digital register.

### Embodiment 10:

The memory circuit according to embodiment 9, wherein each OR gate of the plurality of OR gates is configured to output a value of logic 1 for the reading of bits from the one-time-programmable memory, and wherein each OR gate of the plurality of OR gates is configured to output a value of logic 0 for the reading of bits from the non-volatile memory.

### Embodiment 11:

The memory circuit according to one of embodiments 1 to 10, wherein the controller receives a reset signal indicating that the controller is to output the control signal to the control logic to select the first reference resistance for the sense amplifier from the decoder for the reading of bits from the one-time-programmable memory.

### Embodiment 12:

A method for accessing memory, the memory including a non-volatile memory, a one-time-programmable memory, and a sense amplifier coupled to the non-volatile memory and the one-time-programmable memory, the method comprising:
storing reference resistance bits in a digital register; and
outputting a control signal to control logic for selecting a first reference resistance for the sense amplifier from a decoder for a reading of bits from the one-time-programmable memory, and for selecting a second reference resistance for the sense amplifier from the decoder for a reading of bits from the non-volatile memory.

### Embodiment 13:

The method according to embodiment 12, wherein the first reference resistance is greater than the second reference resistance.

### Embodiment 14:

The method according to embodiment 12 or 13, wherein the bits read from the one-time-programmable memory include trim fuse bits.

### Embodiment 15:

The method according to one of embodiments 12 to 14, further comprising outputting, by the control logic, an address for selecting a reference resistance from the decoder.

### Embodiment 16:

The method according to one of embodiments 12 to 15, further comprising outputting, by a controller, the control signal to the control logic during a power-on-reset process.

### Embodiment 17:

The method according to one of embodiments 12 to 16, further comprising:
receiving, by the controller, a reset signal indicating a start of the power-on-reset process; and
outputting, by the controller, the control signal to the control logic to select the first reference resistance for the sense amplifier from the decoder for the reading of bits from the one-time-programmable memory.

### Embodiment 18:

The method according to one of embodiments 12 to 17, wherein the control signal output by the controller has a first value for the reading of bits from the one-time-programmable memory, and wherein the control signal output by the controller has a second value for the reading of bits from the non-volatile memory.

### Embodiment 19:

The method according to one of embodiments 12 to 18, wherein the control logic comprises a plurality of OR gates, wherein a first input of each OR gate of the plurality of OR gates receives a control signal output by a controller.

### Embodiment 20:

The method according to embodiment 19, wherein a second input of each OR gate of the plurality of OR gates receives a respective bit of the reference resistance bits stored in the digital register.

### Embodiment 21:

The method of one of embodiments 12 to 20, wherein the memory circuit of one of embodiments 1 to 11 is accessed.

## Claims

1. A memory circuit, comprising:
a non-volatile memory;
a one-time-programmable memory;
a sense amplifier coupled to the non-volatile memory and the one-time-programmable memory;
a digital register coupled to an output of the sense amplifier for storing reference resistance bits;
control logic coupled to an output of the digital register;
a decoder coupled to an output of the control logic; and
a controller for outputting a control signal to the control logic to select a first reference resistance for the sense amplifier from the decoder for a reading of bits from the one-time-programmable memory, and to select a second reference resistance for the sense amplifier from the decoder for a reading of bits from the non-volatile memory.

2. The memory circuit according to claim 1, wherein the first reference resistance is greater than the second reference resistance, and/or
wherein a portion of the non-volatile memory includes the one-time-programmable memory.

3. The memory circuit according to claim 1 or 2, wherein the controller outputs the control signal to the control logic during a power-on-reset process, and/or
wherein the bits read from the one-time-programmable memory include trim fuse bits.

4. The memory circuit according to one of claims 1 to 3, wherein the control logic outputs an address to the decoder for selecting a reference resistance from the decoder, and/or
wherein the control signal output by the controller has a first value for the reading of bits from the one-time-programmable memory, and wherein the control signal output by the controller has a second value for the reading of bits from the non-volatile memory.

5. The memory circuit according to one of claims 1 to 4, wherein the control logic comprises a plurality of OR gates, wherein a first input of each OR gate of the plurality of OR gates receives the control signal output by the controller,

6. The memory circuit according to claim 5, wherein a second input of each OR gate of the plurality of OR gates preferably receives a respective bit of the reference resistance bits stored in the digital register.

7. The memory circuit according to claim 6, wherein each OR gate of the plurality of OR gates is configured to output a value of logic 1 for the reading of bits from the one-time-programmable memory, and wherein each OR gate of the plurality of OR gates is configured to output a value of logic 0 for the reading of bits from the non-volatile memory,

8. The memory circuit according to one of claims 1 to 7, wherein the controller receives a reset signal indicating that the controller is to output the control signal to the control logic to select the first reference resistance for the sense amplifier from the decoder for the reading of bits from the one-time-programmable memory.

9. A method for accessing memory, the memory including a non-volatile memory, a one-time-programmable memory, and a sense amplifier coupled to the non-volatile memory and the one-time-programmable memory, the method comprising:
storing reference resistance bits in a digital register; and
outputting a control signal to control logic for selecting a first reference resistance for the sense amplifier from a decoder for a reading of bits from the one-time-programmable memory, and for selecting a second reference resistance for the sense amplifier from the decoder for a reading of bits from the non-volatile memory.

10. The method according to claim 9, wherein the first reference resistance is greater than the second reference resistance, and/or
wherein the bits read from the one-time-programmable memory include trim fuse bits.

11. The method according to claim 9 or 10, further comprising at least one of:
outputting, by the control logic, an address for selecting a reference resistance from the decoder; and
outputting, by a controller, the control signal to the control logic during a power-on-reset process.

12. The method according to one of claims 9 to 11, further comprising:
receiving, by the controller, a reset signal indicating a start of the power-on-reset process; and
outputting, by the controller, the control signal to the control logic to select the first reference resistance for the sense amplifier from the decoder for the reading of bits from the one-time-programmable memory.

13. The method according to one of claims 9 to 12, wherein the control signal output by the controller has a first value for the reading of bits from the one-time-programmable memory, and wherein the control signal output by the controller has a second value for the reading of bits from the non-volatile memory.

14. The method according to one of claims 9 to 13, wherein the control logic comprises a plurality of OR gates, wherein a first input of each OR gate of the plurality of OR gates receives a control signal output by a controller.

15. The method according to claim 14, wherein a second input of each OR gate of the plurality of OR gates receives a respective bit of the reference resistance bits stored in the digital register.
